# EUROPEAN PATENT APPLICATION

(11) **EP 4 556 930 A1**
(43) Date of publication of application: **21.05.2025**
(21) Application number: 24211171.4
(22) Date of filing: 06.11.2024
(51) Int. Cl.: G01R 33/09

(54) **TMR SENSOR HAVING TUNED VORTEX RESPONSE**

(30) Priority: 16.11.2023 US 202318511743
(71) Applicant: Allegro MicroSystems, LLC, Manchester, NH 03103-3353 (US)
(72) Inventor: CAMPIGLIO, Paolo, Arcueil (FR); JAISWAL, Samridh, London (GB); RIOULT, Maxime, Massy (FR); BELIN, Noémie, Villejuif (FR)
(74) Representative: South, Nicholas Geoffrey

(57) **Abstract**

Methods and apparatus for a device having a TMR element that includes a free layer, a spacer layer, and a reference layer. In embodiments, the free layer comprises a vortex layer configured to provide a magnetic vortex, and a coupling layer magnetically coupled to the vortex layer to modulate the vortex in the vortex layer.

## Description

### BACKGROUND

Magnetic field sensors are used in a variety of applications, including, but not limited to, an angle sensor that senses an angle of a direction of a magnetic field, a current sensor that senses a magnetic field generated by a current carried by a current-carrying conductor, a magnetic switch that senses the proximity of a ferromagnetic object, a rotation detector that senses passing ferromagnetic articles, for example, magnetic domains of a ring magnet or a ferromagnetic target (e.g., gear teeth) where the magnetic field sensor is used in combination with a back-biased or other magnet, and a magnetic field sensor that senses a magnetic field density of a magnetic field.

In certain applications, magnetic field sensors include magnetoresistance elements. These elements have an electrical resistance that changes in the presence of an external magnetic field. Spin valves are a type of magnetoresistance element formed from two or more magnetic materials or layers. The simplest form of a spin valve has a reference (or magnetically fixed) layer and a free layer. The resistance of the spin valve changes as a function of the magnetic alignment of the reference and free layers. Typically, the magnetic alignment of the reference layer does not change, while the magnetic alignment of the free layer moves in response to external magnetic fields.

In some cases, a spin valve may also have a bias. The bias may be generated by one or more magnetic layers (bias layers) that are magnetically coupled to the free layer. In the absence of an external magnetic field, the bias layers may cause the magnetic alignment of the free layer to default to a predetermined alignment. The magnetic coupling between the bias layers and the free layer is relatively weak so that an external field can override the bias and realign the magnetic alignment of the free layer.

### SUMMARY

Embodiments of the disclosure provide methods and apparatus for a TMR sensor having a tuned vortex response due to a magnetically coupled layer. In embodiments, a TMR stackup includes a vortex layer coupled to a magnetic layer which may have perpendicular anisotropy. The magnetic coupling should be low enough to maintain the vortex and increase the core size of the vortex because in the vortex center the magnetic moments point outside of the plane of the sample and the coupling with a perpendicular magnetic layer favors this orientation, which also lies in the out of plane direction, and enlarges the core.

In one aspect, device comprises: a TMR element comprising a free layer, a spacer layer, and a reference layer, wherein the free layer comprises: a vortex layer configured to provide a magnetic vortex; and a perpendicular layer having a magnetic field orientation that is perpendicular to a plane of the vortex layer.

A device can further include one or more of the following features: the free layer comprises, in order of increasing distance from the spacer layer: the perpendicular layer: a coupling spacer; and the vortex layer, the spacer layer comprises MgO, the perpendicular layer comprises CoFeB, the coupling spacer comprises Ru, the vortex layer comprises NiFe, magnetic coupling of the vortex layer and the perpendicular layer is configured to maintain the magnetic vortex and to increase a core size of the magnetic vortex, the perpendicular layer comprises a material having anisotropy that is perpendicular to the vortex layer, the free layer comprises, in order of increasing distance from the spacer layer: the vortex layer; a coupling layer; and the perpendicular layer, the spacer layer comprises MgO, the perpendicular layer comprises CoPt, the perpendicular layer comprises one or more of Co/Pt, Co/Pd, CoFe/Pd, CoPt, FePt and/or CoFeB/MgO, the coupling layer comprises Ru, the vortex layer comprises one or more of CoFeB and/or NiFe, and/or the device is configured for in-plane sensing.

In another aspect, a method comprises: forming a TMR element comprising a free layer, a spacer layer, and a reference layer, wherein forming the free layer comprises: configuring a vortex layer to provide a magnetic vortex; and forming a perpendicular layer having a magnetic field orientation that is perpendicular to a plane of the vortex layer.

A method can further include one or more of the following features: the free layer comprises, in order of increasing distance from the spacer layer: the perpendicular layer: a coupling spacer; and the vortex layer, the spacer layer comprises MgO, the perpendicular layer comprises CoFeB, the coupling spacer comprises Ru, the vortex layer comprises NiFe, magnetic coupling of the vortex layer and the perpendicular layer is configured to maintain the magnetic vortex and to increase a core size of the magnetic vortex, the perpendicular layer comprises a material having anisotropy that is perpendicular to the vortex layer, the free layer comprises, in order of increasing distance from the spacer layer: the vortex layer; a coupling layer; and the perpendicular layer, the spacer layer comprises MgO, the perpendicular layer comprises CoPt, the perpendicular layer comprises one or more of Co/Pt, Co/Pd, CoFe/Pd, CoPt, FePt and/or CoFeB/MgO, the coupling layer comprises Ru, the vortex layer comprises one or more of CoFeB and/or NiFe, and/or the device is configured for in-plane sensing.

### BRIEF DESCRIPTION OF THE DRAWINGS

The foregoing features of this invention, as well as the invention itself, may be more fully understood from the following description of the drawings in which:
FIG. 1 is a schematic representation of an example sensor having a TMR element with tuned vortex characteristics;
FIG. 2 is schematic representation of a TMR bridge with TMRs element with tuned vortex characteristics;
FIG. 3 is a schematic representation of a bridge resistor having TMR pillars with tuned vortex characteristics;
FIG. 4 is a schematic representation of a MTJ with tunneling magnetoresistance;
FIG. 5 is an example TMR element stackup having tuned vortex characteristics;
FIG. 6 is a schematic representation of a vortex in a vortex layer magnetic coupling to a coupling layer;
FIG. 7 is an example of another TMR element stackup having tuned vortex characteristics;
FIG. 8 is an example of another TMR element stackup having tuned vortex characteristics;
FIG. 9 is an example another TMR element stackup having tuned vortex characteristics;
FIG. 10 is a flow diagram of an example sequence of steps for a TMR element having tuned vortex characteristics.

### DETAILED DESCRIPTION

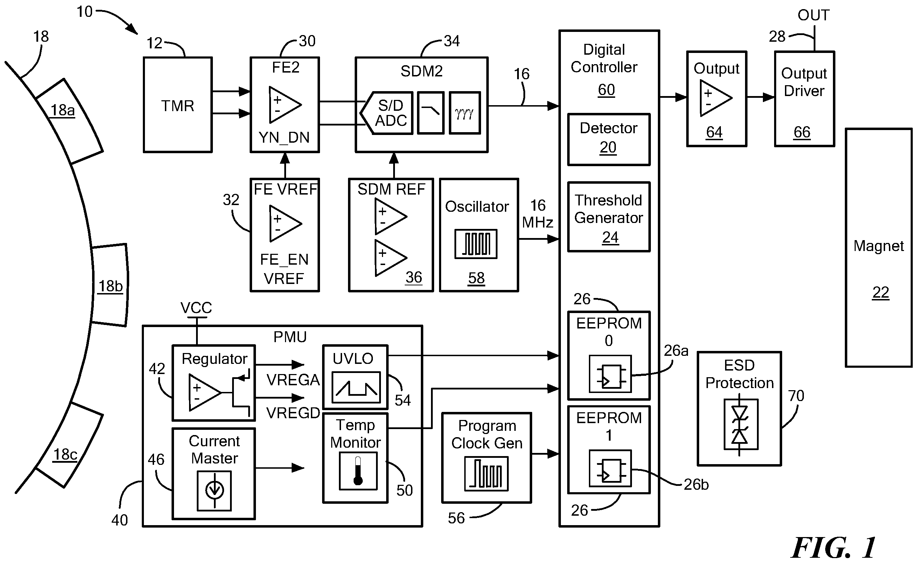

FIG. 1 shows an example magnetic field sensor 10 having at least one magnetic field sensing element 12 that includes one or more TMR elements having a tuned vortex in accordance with example embodiments of the disclosure. The sensor 10 is configured to generate a magnetic field signal 16 indicative of a magnetic field associated with a target 18 and a detector 20 responsive to the magnetic field signal and to a threshold level from a threshold generator 24 to generate a sensor output signal 28 containing transitions associated with features of the target in response to the magnetic field signal crossing the threshold level.

The target 18 can have a variety of forms, including, but not limited to a gear having gear teeth 18a - 18c or a ring magnet having one or more pole pair. Also, linear arrangements of ferromagnetic objects that move linearly are possible. In the example embedment of FIG. 1, magnetic field sensor 10 may take the form of a rotation detector to detect passing gear teeth, for example, gear teeth 18a-18c of a ferromagnetic gear or, more generally, target object 18. A permanent magnet 22 can be placed at a variety of positions proximate to the gear 18, resulting in fluctuations of a magnetic field proximate to the gear as the gear rotates in a so-called "back-bias" arrangement.

Features of the target 18 are spaced from the sensing elements 12 by an airgap. Although intended to be fixed once the sensor 10 is in place in a particular application, the airgap can vary for a variety of reasons. A difference between angles of the transitions of the sensor output signal 28 and locations of the associated features 18a - 18c of the target 28 is referred to as a "hard offset."

Sensing elements 12 can take a variety of forms, such as TMR elements, as may be arranged in one or more bridge or other configurations in order to generate one or more single-ended or differential signals indicative of the sensed magnetic field. A front-end amplifier 30 can be used to process the magnetic field sensing element output signal to generate a further signal for coupling to an analog-to-digital converter (ADC) 34 as may include one or more filters, such as a low pass filter and/or notch filter, and as may take the form of a sigma delta modulator to generate a digital magnetic field signal 16. Features of the magnetic field signal processing can include a front-end reference 32 and a sigma delta reference 36.

Sensor 10 includes a power management unit (PMU) 40 as may contain various circuitry to perform power management functions. For example, a regulator 42 can output a regulated voltage for powering analog circuitry of the sensor (VREGA) and/or a regulated voltage for powering digital circuitry of the sensor (VREGD). A bias current source 46, a temperature monitor 50 and an undervoltage lockout 54 can monitor current, temperature, and voltage levels and provide associated status signals to a digital controller 60. A clock generation element 56 and an oscillator 58 are coupled to the digital controller 60.

Digital controller 60 processes the magnetic field signal 16 to determine the speed, position, and/or direction of movement, such as rotation of target 18 and outputs one or more digital signals to an output protocol module 64. More particularly, controller 60 determines the speed, position, and/or direction of target 18 based on the magnetic field signal 16 and can combine this information with fault information in some embodiments to generate the sensor output signal 28 in various formats. The output of module 64 is fed to an output driver 66 that provides the sensor output signal 28 in various formats, such as a so-called two-wire format in which the output signal is provided in the form of current pulses on the power connection to the sensor or a three-wire format in which the output signal is provided at a separate dedicated output connection. Formats of the output signal 28 can include variety of formats, for example a pulse-width modulated (PWM) signal format, a Single Edge Nibble Transmission (SENT) format, a Serial Peripheral Interface (SPI) format, a Local Interconnect Network (LIN) format, a CAN (Controller Area Network) format, an Inter-Integrated Circuit (I²C) format, or other similar signal formats. Sensor 10 can further include electrostatic discharge (ESD) protection 70.

The digital controller 60 includes detector 20, threshold generator 24, and memory 26 such as EEPROMs 26a, 26b. Memory 26 can be used to store values for various sensor functionality including storing function coefficients for use by the threshold generator 24 in generating the adaptive threshold levels for use by detector 20.

Detector 20 is coupled to receive the threshold level thus generated and the magnetic field signal 16 and compare the received levels to generate a binary, two-state, detector output signal that has transitions when the signal 16 crosses the threshold level. Movement speed of the target 18 can be detected in accordance with the frequency of the binary signal.

It should be appreciated that a direction of rotation of the target 28 may be determined in embodiments containing multiple sensing elements 12 configured to generate phase separated magnetic field signals (as are sometimes referred to as channel signals), in which case the direction of rotation can be determined based on a relative phase or relative time difference (e.g., lag or lead) of a particular edge transition of detector output signals associated with the phase separated magnetic field signals.

It is understood that embodiments of TMR-based sensing elements are useful in a wide variety of magnetic sensors. While an example sensor is shown and described above, any practical magnetic sensor in which TMR sensing elements are desirable can be provided. For example, TMR sensing elements are useful in many magnetic positions and angle sensors that require high resolution. Further example sensors in which TMR-based sensing elements are shown and described below.

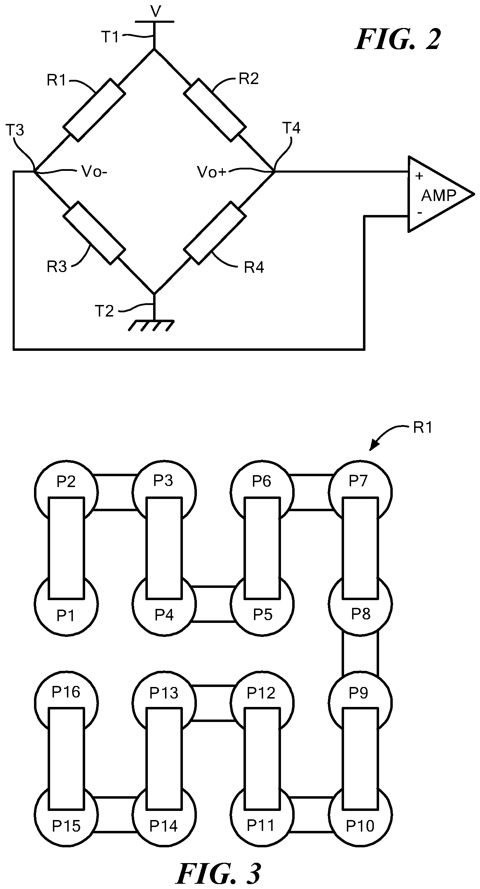

FIG. 2 shows an example TMR bridge 200 having a first resistor R1, a second resistor R2, a third resistor R3, and fourth resistor R4 coupled in a bridge configuration, which can correspond to the sensing elements 12 of FIG. 1. A first terminal T1 is coupled to a voltage supply and a second terminal T2 is coupled to ground (or other potential). A third terminal T3 provides a first differential output signal Vo- and a fourth terminal T4 provides a second differential output signal Vo+. The differential output Vo+, Vo- of the bridge can be provided to an amplifier AMP or other circuitry for processing of the output of the magnetic field sensing elements, such as described above.

FIG. 3 shows an example implementation in which bridge resistor R1 contains sixteen pillars P1-16 that provide the total resistance for R1. It is understood that a TMR resistor that provides a leg of the bridge can comprise any practical number of pillars connected in series and/or in parallel to provide the TMR bridge resistor. Pillars can be designed to have the same or different resistances.

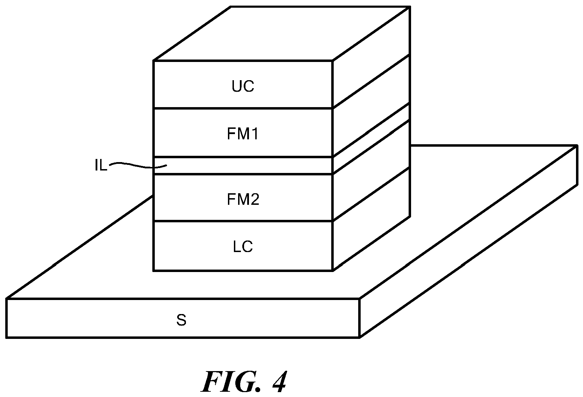

FIG. 4 shows an example magnetic tunnel junction (MTJ) that uses TMR to provide TMR elements, e.g., pillars. As is known in the art, tunneling magnetoresistance (TMR) occurs in a magnetic tunnel junction (MTJ) which has first and second ferromagnets FM1, FM2 separated by a thin insulative layer IL, such as MgO. An upper contact UC can be provided on the first ferromagnet FM1 and a lower contact LC can be provided on the second ferromagnet FM2. A substrate S can support the MTJ structure. The insulative layer should be thin, in the order of a few nanometers, so as to allow electrons to 'tunnel' from one of the ferromagnets to the other. It will be appreciated that this is a quantum mechanical phenomenon.

The direction of the two magnetizations of the ferromagnetic films FM1, FM2 can be switched individually by an external magnetic field. If the magnetizations are in a parallel orientation, it is more likely that electrons will tunnel through the insulating film IL than if they are in the oppositional (antiparallel) orientation. Consequently, such a junction can be switched between two states of electrical resistance, one with low resistance and one with high resistance.

It is understood that the directions of FM1 and FM2 do not necessarily have to be switched: if the external field angle is neither parallel or anti-parallel then the resulting magnetization changes as the composite angle between the external field and the reference layer. The resistance variation is proportional to the cosine of such composite angle which makes TMR elements useful for angle sensing applications.

Electrons with certain spin orientation ("spin-up" or "spin-down") can tunnel from one ferromagnetic layer to another ferromagnetic layer through the non-conductive thin insulating layer if there are available free states with the same spin orientation. In case of the parallel state, the majority spin ("spin-up") electrons and minority spin ("spin-down") electrons can tunnel to the second ferromagnetic layer and fill majority ("up") and minority ("down") states, respectively. This will result in large conductance and corresponds to the low resistive state. In case of the anti-parallel state, the majority spin ("spin-down") electrons and minority spin ("spin-up") electrons from first ferromagnetic layer fill the minority ("down") and majority ("up") states in the second ferromagnetic layer, respectively. This will result in the low conductance and corresponds to the high resistive state. Tunneling magnetoresistance is described in J. Mathon, Theory of Tunneling Magnetoresistance, 76 PHASE TRANSITIONS 491-500 (2003), which is incorporated herein by reference.

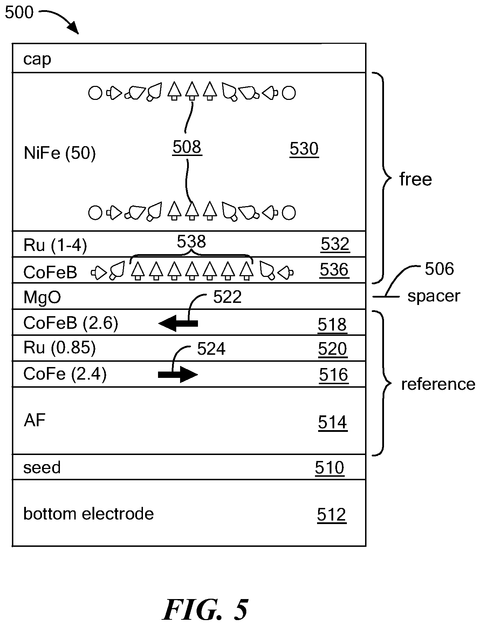

FIG. 5 is a block diagram of an example magnetoresistance element 500 having a plurality of material layers stacked on top of one another and configured to have tuned vortex characteristics in accordance with example embodiments of the disclosure. Each of the material layers in the stack has electrical and magnetic properties which, when placed together, cause the magnetoresistance element 500 to react to external magnetic fields. In embodiments, the magnetoresistance element 500 comprises a spin valve. Spin valves minimally have three layers: a fixed (also referred to as a reference) layer having a fixed magnetic alignment, a free layer having a magnetic alignment that changes in response to an external magnetic field and an insulating layer separating the two. When the magnetic alignment of the free layer is lined up with the magnetic alignment of the reference layer, the electrical resistance of the spin valve has a minimal value. Conversely, when the magnetic alignment of the free layer is aligned in an opposite direction to the reference layer, the electrical resistance of the spin valve is at a maximum value. At points in between, the resistance is at an intermediate value. Generally, as the magnetic alignment of the free layer changes from one extreme (e.g., oppositely aligned with the reference layer) to the other extreme (e.g., aligned with the reference layer), the electrical resistance of the spin valve changes linearly from its maximum value to its small value. The TMR element 500 can be driven with a current that flows between the bottom electrode and the cap.

As shown and described more fully below, perpendicular magnetic anisotropy (PMA)/vortex interaction can be achieved in different ways depending on which layer is close to a spacer layer, e.g., MgO, since this layer is the one imparting a specific response to the TMR. If the vortex layer is closer to the MgO layer, then the PMA is the coupling layer because it modulates the response of the vortex by enlarging its core. If the PMA layer is the one closer to the MgO (see, e.g., FIG. 5), the vortex becomes the coupling layer and induces a twirling in the PMA stack, which now also adopts a vortex state with an enlarged core.

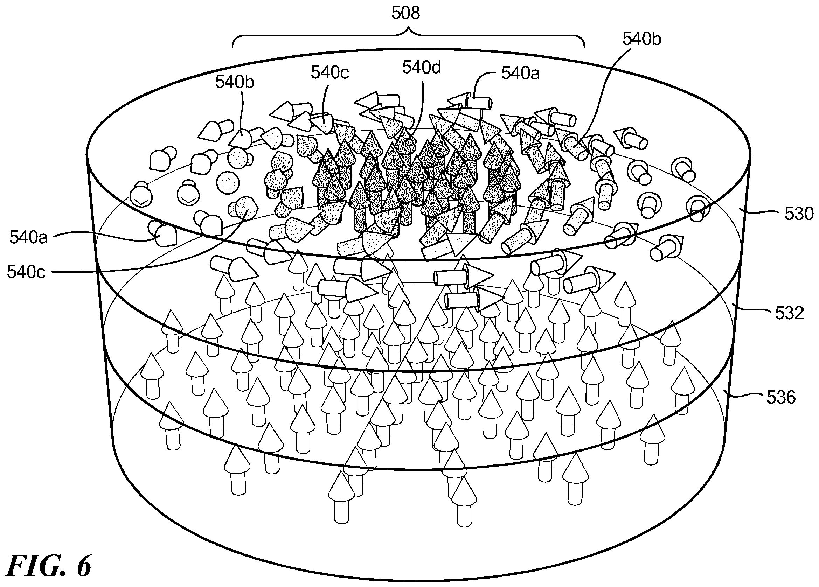

Referring now to FIG. 5 and FIG. 6, an example TMR element 500 is shown having a free layer 502 and a reference layer 504 separated by a spacer layer 506 which combine to enable a magnetic vortex 508 indicated by a series of cylindrical arrows 540a-d indicative of orientation. The reference layer 504 may be disposed on a seed layer 510 e.g., an Ru layer, coupled to an electrode 512. The layers in the stack have electrical and magnetic properties which, when placed together, cause the magnetoresistance element 500 to react to external magnetic fields. The TMR element 500 is a spin valve device so that the electrical resistance of magnetoresistance element changes as the magnetic alignment between different material layers changes. In the illustrated embodiment, the TMR element 500 has a stack of layers indicative of one pillar of a multi-pillar TMR element.

The reference layer 504 can include an antiferromagnetic (AF) layer 514 located on the seed layer 510. The reference layer 504 can further include first and second pinned layers 516, 518 separated by a spacer 520. In one embodiment, the first layer 516 comprises CoFe, the second pinned layer 518 comprises CoFeB, and the spacer 520 comprises Ru, with the first and second pinned layers having in plane field sensitivity and opposite orientation, as indicated by the respective arrows 522, 524.

In the illustrated embodiment, the spacer layer 506 comprises MgO and may contribute to coupling with the vortex layer. Some spacing layers can be used to tune coupling, but not MgO. With regard to coupling between ferromagnetic layers, the primary mechanism is a RKKY coupling, which implies a metallic spacer. Since MgO is insulating, there is little or no RKKY coupling. In FIG. 5, for example, the interaction between the perpendicular magnetized layer, such as layer 536, and the vortex is managed through an Ru spacer, such as layer 532.

The free layer 502 includes a vortex layer 530, which can comprise NiFe, for example. Below the vortex layer 530, the free layer 502 comprises a free layer spacer 532 between the vortex layer 530 and a PMA layer 536 of the free layer. In the illustrated embodiment, the PMA layer 536 comprises CoFeB. The perpendicular layer 536 in the free layer is magnetically coupled to the vortex layer 530 with perpendicular anisotropy, as indicated by arrow 538.

A magnetic vortex 508 may be formed in the vortex layer 530 of the TMR element 500. As is best seen in FIG. 6, the magnetic vortex 508 has magnetization directions (e.g., a magnetization direction 540a, magnetization direction 540b, magnetization direction 540c, magnetization direction 540d) that loop around the free layer 502. An angle of the magnetization direction 540a with respect to a surface of the free layer 502 is about 0° at the outer edges of the free layer. The magnetic vortex has a core (sometimes called a "magnetic vortex core") having a center that is coaxial with a center of the vortex layer. The magnetization directions 540 become more and more nonplanar the closer to the center of the core. That is, the angle of the magnetization direction 540 with respect to the surface of the free layer 502 increases the closer to the center of the core a magnetization direction is. For example, an angle of the magnetization direction 540b with respect to the surface of the free layer 502 is higher than the angle of the magnetization direction 540a with respect to the surface of the free layer 502, an angle of the magnetization direction 540c with respect to the surface of the free layer 502 is higher than the angle of the magnetization direction 540b with respect to the surface of the free layer 502, and an angle of the magnetization direction 540d with respect to the surface of the free layer 502 is higher than the angle of the magnetization direction 540c with respect to the surface of the free layer 502.

The PMA layer 536 has an anisotropy orientation that is aligned with the magnetization direction 540d at the center of the vortex core. The magnetic coupling of layers 530,536 should be low enough to maintain the vortex 508 and increase the core size of the vortex because in the vortex center the magnetic moments point, e.g., 540c,d, outside of the plane of the sample (see FIG. 6) and the coupling with a perpendicular magnetic layer favors this orientation, which also lies in the out of plane direction, and enlarges the core.

It is understood that the vortex 508 can rotate in a direction opposite to that shown in the illustrative embodiment of FIG. 6. That is, the vortex can have opposite chirality. In addition, in other embodiments, the coupling layer 536 can have perpendicular anisotropy in the opposite direction to that shown. That is, the polarity/orientation of the coupling layer can be "down" instead of "up."

Magnetic anisotropy refers to how the magnetization changes depending on its orientation. One can identify a volume contribution, which pushes the magnetization in the plane of the layer (parallel anisotropy) and an interface/surface contribution, which makes perpendicular anisotropy. Perpendicular anisotropy may be the most favorable one energetically. As such, perpendicular anisotropy is achieved in thin layers, if proper materials are used at the interface. For example, CoFeB/MgO and Co/Pt interfaces induce high interface anisotropy, thus favoring a perpendicular magnetic anisotropy. If the perpendicular layer is the coupling layer, then its anisotropy can be very strong so that it should be controlled to ensure that the coupling does not destroy the vortex. If the vortex is the biasing layer, then the perpendicular anisotropy should not be very strong, since a vortex needs to be induced into the perpendicular layer, which will thus become not perpendicular, but will have a vortex with a larger core.

FIGs. 5 and 6 show an example TMR structure 500 having tuned vortex characteristics in accordance with example embodiments of the disclosure. The response of the TMR element 500 is determined by the behavior of the core, around which the vortex 508 rotates. When a magnetic field is applied, the vortex 508 displaces in such a way to favor the magnetic momentum aligned along the field direction. The larger the vortex core with respect to the pillar, the more difficult it is to move the vortex, since the core becomes stiffer or heavier due to the increased effective magnetization of the larger vortex core and the magnetic volume becomes larger.

In example embodiments, the TMR element sensor has a tuned vortex response due to perpendicular magnetic anisotropy in the PMA layer 536 that can modulate the vortex 508 characteristics. In this embodiment, the PMA layer 536 can be considered the perpendicular layer. In embodiments, the TMR stackup couples the magnetic (vortex) layer 530 that establishes the vortex with the magnetic coupling layer 536 having perpendicular magnetic anisotropy. The magnetic coupling should be low enough to maintain the vortex 508 and strong enough to induce a vortex in the PMA layer 536. The perpendicular magnetic coupling inside the layer 536 will increase the core size of the vortex with respect to what would be obtained to a non-coupled vortex 508.

In embodiments, coupling a magnetic vortex layer 530 with a perpendicular magnetic coupling layer 536 ensures that the vortex 508 has the same polarity (since the degeneracy between the up and down state of the core is removed) so that hysteresis is reduced. In addition, the perpendicular coupling modifies the annihilation/nucleation behavior of the vortex.

A coupling of the vortex 508 can be achieved with RKKY interaction, where the thickness of the spacer (usually Ru) modulates the direction and the amplitude of the coupling. It is understood that RKKY (Ruderman-Kittel-Kasuya-Yosida) interaction refers to a coupling mechanism of nuclear magnetic moments of localized d- or f- shell electron spins in a metal by means of an interaction through conduction electrons.

The perpendicular magnetic layer may be a relatively thin magnetic layer where the interface anisotropy dominates the volume contribution, orientating the magnetization outside the plane: strong interface anisotropy can be obtained with heavy metals, such as Pt and Pd, or alternatively with the oxygen atoms inside the MgO tunnel barrier.

It is understood that example materials and dimensions are shown to facilitate an understanding of illustrative embodiments of the disclosure and are not intended to limit the scope of the invention as claimed in any way.

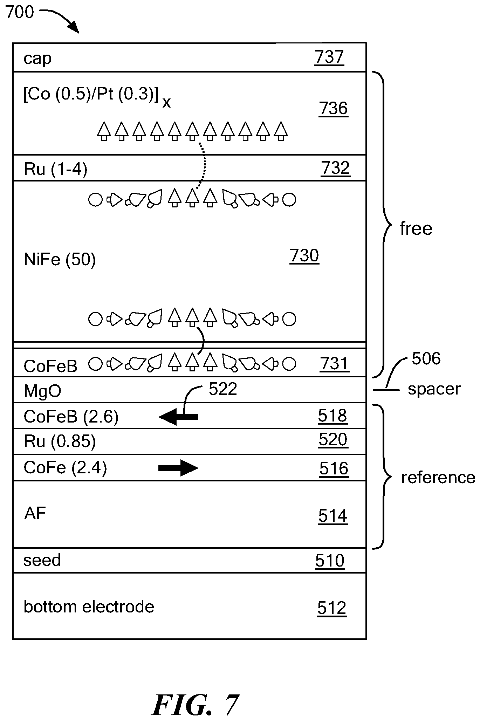

FIG. 7 shows an alternative embodiment of a TMR element 700 having a different free layer configuration than the TMR element 500 of FIG. 5, where like reference numbers indicate like elements. The coupling layer can be considered below the vortex layer in FIG. 5 and above the vortex layer in FIG. 7. The TMR element is configured for in plane field sensitivity.

The TMR element 700 free layer 702 comprises a vortex propagating into a ferromagnetic bi-layer 730, such as an exchanged coupled CoFeB/NiFe (layers 731 and 730), with a CoFeB layer 731, abutting the tunnel barrier 506. In this case the CoFeB is thick enough to have a volume contribution stronger than the interface one, leading to in-plane magnetization. On top of the vortex layer 730, is a spacer 732, such as Ru, and a perpendicular layer 736, which is also a coupling/bias layer. In an example embodiment, the perpendicular layer 736 comprises Co/Pt. A cap 737 can be provided on top of the perpendicular layer 736.

It is understood that the layer 736 needs to be a magnetic layer with perpendicular magnetic anisotropy (PMA). As noted above, PMA provides a strong interface contribution. Layer 736 can comprise bilayers and/or multilayers, such as Co/Pt, Co/Pd, CoFe/Pd, CoPt, FePt and CoFeB/MgO. It is understood that it is the orbital mixes at the interface which enhance the interface contribution. In this configuration, the free layer is the reverse of the configuration of FIG. 5. However, there is a difference between the two cases: if the vortex is close to the tunnel barrier then the perpendicular layer can stay fully aligned, if the perpendicular layer is close to the tunnel barrier then the bias with vortex should induce some rotation in the magnetization.

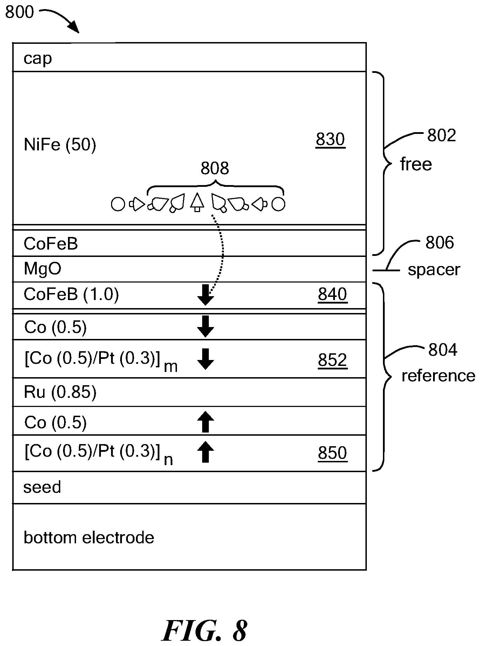

FIG. 8 shows a further embodiment of a TMR element 800 having tuned vortex characteristics in accordance with example embodiments of the disclosure. In embodiments, the TMR element is configured for out-of-plane sensing. The TMR element 800 includes a free layer 802 and a reference layer 804 separated by a spacer layer 806 which combine to enable a magnetic vortex 808. The free layer 802 includes a CoFeB layer and a vortex layer 830. In the illustrated embodiment, the reference layer 804 comprises a CoFeB layer 840 and Co/Pt layers 850, 852 separated by a Co layer and a Ru layer. A Co layer can be located between the layer 840 and the Co/Pt layer 852. In the illustrated embodiment, the fields of the reference layer 804 are configured for out-of-plane sensing, as indicated by the vertical arrows in the indicated direction (up or down).

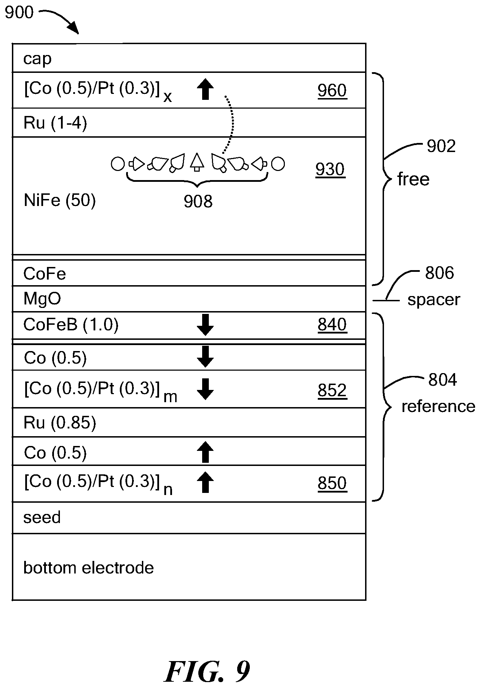

FIG. 9 shows a further embodiment of a TMR element 900 having tuned vortex characteristics with some similarities with the TMR element 800 of FIG. 8, wherein like reference numbers indicated like elements. The TMR element 900 is configured for out-of-plane sensitivity. The spacer 806 and reference layer 804 may have the same configuration as in FIG. 8.

The free layer 902 includes a coupling layer 960 above the vortex layer 930 separated by a spacer 961, which may comprise Ru. The coupling layer 960 tunes the vortex 908 in the vortex layer, as described above. In embodiments, the coupling layer 960 comprises a Co/Pt material for magnetic coupling to the vortex layer 930.

As explained above, when the vortex layer and perpendicular layer are coupled together one obtains some of the behavior of the other depending on the intensity of the coupling. In embodiments, the focus is understanding what happens in the layer which is closer to the spacer layer, e.g., MgO, because this is the layer that controls the TMR response. The other layer is magnetically active but without an electrical response - even if something happens in this layer it is not relevant for the TMR response. This other layer can be referred to as a coupling layer because it is just there to provide a coupling, e.g., a magnetically influence, on the active layer. FIGs. 5 and 7 show different configurations of coupling between the vortex layer and the perpendicular layer.

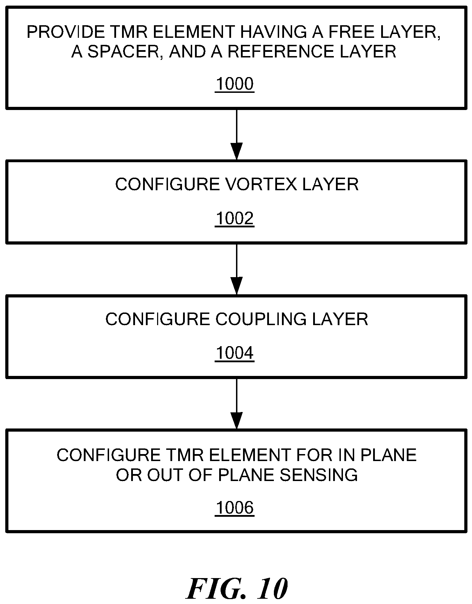

FIG. 10 shows an example sequence of steps for a magnetic field sensing having a TMR element with tuned vortex characteristics. In step 1000, a TMR element having a free layer, a spacer and a reference layer is provided. In step 1002, a vortex layer is configured to provide a magnetic vortex. In step 1004, a coupling layer is magnetically coupled to the vortex layer to modulate the vortex characteristics. In step 1006, the TMR element is configured for in plane sensing or out of plane sensing.

Embodiments of the disclosure are applicable to magnetic sensors in general in which having a tuned vortex is desirable. Example applications include closed and openloop current sensors, position sensors, speed sensors, etc.

Since their core is more difficult to move, tuned vortex sensors have wider linear ranges, which may be useful in applications with higher magnetic fields applied. Without this tuning, a wider linear range can be obtained with a smaller pillar diameter but larger pillars are less challenging to manufacture. Also, the capability of controlling vortex chirality could help to decrease coercivity, as noted above.

As used herein, the term "magnetic field sensor" is used to describe a circuit that uses a magnetic field sensing element, generally in combination with other circuits. Magnetic field sensors are used in a variety of applications, including, but not limited to, an angle sensor that senses an angle of a direction of a magnetic field, a current sensor that senses a magnetic field generated by a current carried by a current-carrying conductor, a magnetic switch that senses the proximity of a ferromagnetic object, a rotation detector that senses passing ferromagnetic articles, for example, magnetic domains of a ring magnet or a ferromagnetic target (e.g., gear teeth) where the magnetic field sensor is used in combination with a back-biased or other magnet, and a magnetic field sensor that senses a magnetic field density of a magnetic field. As used herein, the terms "target" and "magnetic target" are used to describe an object to be sensed or detected by a magnetic field sensor or magnetic field sensing element.

Various embodiments of the concepts, systems, devices, structures and techniques sought to be protected are described herein with reference to the related drawings. Alternative embodiments can be devised without departing from the scope of the concepts, systems, devices, structures and techniques described herein. It is noted that various connections and positional relationships (e.g., over, below, adjacent, etc.) are set forth between elements in the following description and in the drawings. These connections and/or positional relationships, unless specified otherwise, can be direct or indirect, and the described concepts, systems, devices, structures and techniques are not intended to be limiting in this respect. Accordingly, a coupling of entities can refer to either a direct or an indirect coupling, and a positional relationship between entities can be a direct or indirect positional relationship.

As an example of an indirect positional relationship, references in the present description to forming layer "A" over layer "B" include situations in which one or more intermediate layers (e.g., layer "C") is between layer "A" and layer "B" as long as the relevant characteristics and functionalities of layer "A" and layer "B" are not substantially changed by the intermediate layer(s).The following definitions and abbreviations are to be used for the interpretation of the claims and the specification. As used herein, the terms "comprises," "comprising, "includes," "including," "has," "having," "contains" or "containing," or any other variation thereof, are intended to cover a non-exclusive inclusion. For example, a composition, a mixture, process, method, article, or apparatus that comprises a list of elements is not necessarily limited to only those elements but can include other elements not expressly listed or inherent to such composition, mixture, process, method, article, or apparatus.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

Unless otherwise specified, the term "substantially" refers to values that are within ±10%. For example, a first direction that is "substantially" perpendicular to a second direction may refer to a first direction that is within ±10% of making a 90° angle with the second direction.

Having described exemplary embodiments of the disclosure, it will now become apparent to one of ordinary skill in the art that other embodiments incorporating their concepts may also be used. The embodiments contained herein should not be limited to disclosed embodiments but rather should be limited only by the spirit and scope of the appended claims. All publications and references cited herein are expressly incorporated herein by reference in their entirety.

Elements of different embodiments described herein may be combined to form other embodiments not specifically set forth above. Various elements, which are described in the context of a single embodiment, may also be provided separately or in any suitable subcombination. Other embodiments not specifically described herein are also within the scope of the following claims.

## Claims

1. A device, comprising:
a TMR element comprising a free layer, a spacer layer, and a reference layer, wherein the free layer comprises:
a vortex layer configured to provide a magnetic vortex; and
a perpendicular layer having a magnetic field orientation that is perpendicular to a plane of the vortex layer.

2. The device according to claim 1, wherein the free layer comprises, in order of increasing distance from the spacer layer:
the perpendicular layer:
a coupling spacer; and
the vortex layer.

3. The device according to claim 1, wherein the free layer comprises, in order of increasing distance from the spacer layer:
the vortex layer;
a coupling layer; and
the perpendicular layer.

4. A method, comprising:
forming a TMR element comprising a free layer, a spacer layer, and a reference layer, wherein forming the free layer comprises:
configuring a vortex layer to provide a magnetic vortex; and
forming a perpendicular layer having a magnetic field orientation that is perpendicular to a plane of the vortex layer.

5. The method according to claim 16, wherein the free layer comprises, in order of increasing distance from the spacer layer:
the perpendicular layer:
a coupling spacer; and
the vortex layer.

6. The method according to claim 5, or the device according to claim 2, wherein the perpendicular layer comprises CoFeB.

7. The method according to claim 5, or the device according to claim 2, wherein the coupling spacer comprises Ru.

8. The method according to claim 5, or the device according to claim 2, wherein the vortex layer comprises NiFe.

9. The method according to claim 5, or the device according to claim 2, wherein magnetic coupling of the vortex layer and the perpendicular layer is configured to maintain the magnetic vortex and to increase a core size of the magnetic vortex.

10. The method according to claim 5, or the device according to claim 2, wherein the perpendicular layer comprises a material having anisotropy that is perpendicular to the vortex layer.

11. The method according to claim 4, wherein the free layer comprises, in order of increasing distance from the spacer layer:
the vortex layer;
a coupling layer; and
the perpendicular layer.

12. The method according to claim 5 or 11, or the device according to claim 2 or 3, wherein the spacer layer comprises MgO.

13. The method according to claim 11, or the device according to claim 3, wherein the perpendicular layer comprises CoPt.

14. The method according to claim 11, or the device according to claim 3, wherein the perpendicular layer comprises one or more of Co/Pt, Co/Pd, CoFe/Pd, CoPt, FePt and/or CoFeB/MgO.

15. The method according to claim 11, or the device according to claim 3, wherein the coupling layer comprises Ru.

16. The method according to claim 11, or the device according to claim 3, wherein the vortex layer comprises one or more of CoFeB and/or NiFe.

17. The method according to claim 11, or the device according to claim 3, wherein the TMR element is configured for in-plane sensing.
